# EUROPEAN PATENT APPLICATION

(11) **EP 2 453 467 A1**
(43) Date of publication of application: **16.05.2012**
(21) Application number: 10796968.5
(22) Date of filing: 31.05.2010
(51) Int. Cl.: H01L 21/301, C09J 5/00, C09J 7/02, C09J 201/00

(54) **FILM FOR SEMICONDUCTOR AND SEMICONDUCTOR DEVICE MANUFACTURING METHOD**

(30) Priority: 09.07.2009 JP 2009163034
(71) Applicant: Sumitomo Bakelite Company Limited, Shinagawa-ku Tokyo 140-0002 (JP)
(72) Inventor: YASUDA Hiroyuki, Tokyo 140-0002 (JP); HIRANO Takashi, Tokyo 140-0002 (JP)
(74) Representative: Solf, Alexander
(86) International application number: PCT/JP2010/059188
(87) International publication number: WO 2011/004657

(57) **Abstract**

A film for semiconductor includes a support film, a second adhesive layer, a first adhesive layer and a bonding layer which are laminated together in this order. This film for semiconductor is configured so that it supports a semiconductor wafer laminated on the bonding layer thereof when the semiconductor wafer is diced and the bonding layer is selectively peeled off from the first adhesive layer when the diced semiconductor wafer (semiconductor element) is picked up. This film for semiconductor is **characterized in that** when the semiconductor wafer is laminated thereon and diced, and then adhesive strength of the obtained semiconductor element is measured, a ratio of "a (N/cm)" which is adhesive strength of an edge portion of the semiconductor element to "b (N/cm)" which is adhesive strength of a portion of the semiconductor element other than the edge portion thereof (that is, a/b) is in the range of 1 to 4. By optimizing the a/b, it is possible to reliably suppress defects such as breakage and crack which would be generated in the semiconductor element due to local importation of a large load thereto when being picked up.

## Description

### TECHNICAL FIELD

The present invention relates to a film for semiconductor and a semiconductor device manufacturing method (that is, a method for manufacturing a semiconductor device).

### BACKGROUND ART

According to the recent trend of high functionality of electronic devices and expansion of their use to mobile applications, there is an increasing demand for developing a semiconductor device having high density and high integration. As a result, an IC package having high capacity and high density is developed.

In a method for manufacturing the semiconductor device, a bonding sheet is, first, attached to a semiconductor wafer made of silicon, gallium, arsenic or the like, and then the semiconductor wafer is fixed using a wafer ring at a peripheral portion thereof and is diced (or segmented) into individual semiconductor elements during a dicing step.

Next, an expanding step in which the semiconductor elements obtained by the dicing are separated from each other and a pickup step in which the separated semiconductor elements are picked up are carried out. Thereafter, the picked up semiconductor elements are transferred into a die bonding step in which each picked up semiconductor element is mounted onto a metal lead frame or a substrate (e.g., a tape substrate, an organic hard substrate). In this way, the semiconductor device can be obtained.

Further, by laminating the picked up semiconductor element onto another semiconductor element during the die bonding step, it is also possible to obtain a chip stack-type semiconductor device including a plurality of semiconductor elements in one package.

As the bonding sheet which can be used in such a method for manufacturing a semiconductor device, a bonding sheet in which a first adhesive bonding layer and a second adhesive bonding layer are laminated together in this order onto a base film is known (for example, Patent Document 1).

As described above, this bonding sheet is attached to a semiconductor wafer in the above dicing step. During the dicing step, cutting lines are formed so that an edge of a dicing blade comes down to the base film, to thereby dice the semiconductor wafer and the two adhesive bonding layers into a plurality of parts.

Thereafter, during the pickup step, the two adhesive bonding layers are peeled off from the base film at an interface therebetween, to thereby pick up a semiconductor element (that is, the diced semiconductor wafer) together with the diced two adhesive bonding layers. The picked up two adhesive bonding layers are used for bonding the semiconductor element obtained by the dicing to a metal lead frame (or a substrate) during the die bonding step.

In manufacturing the semiconductor device, required is an excellent pickup property, that is, a property by which an interface to be peeled off (e.g., the interface between the base film and the two adhesive bonding layers in the case of Patent Document 1) can be easily and reliably peeled off without generating defects such as breakage and crack. However, there is a problem in that the pickup property cannot be satisfied in the conventional method.

### PRIOR ART DOCTYMENT

### PATENT DOCUMENT

Patent Document 1: JP-A 2004-43761

### OUTLINE OF THE INVENTION

In the case where the dicing blade comes down to the base film, the base film is shaved so that shavings thereof are produced. The shavings move in the vicinity of the adhesive bonding layers or in the vicinity of the semiconductor element through the cutting lines. As a result, the shavings, for example, stick to the picked up semiconductor elements, penetrate into between the semiconductor element and the metal lead frame or the substrate during the bonding step, or adhere to the semiconductor element. This causes various defects.

On the other hand, in the case where the dicing blade does not come down to the base film but cutting lines come down to the adhesive bonding layers, components contained in the adhesive bonding layers exude through the cutting lines. These components cause, especially, undesired increase of adhesive strength of an edge portion of each semiconductor element. As a result, there is a fear that a load is locally applied to the semiconductor element when being picked up, to thereby generate defects such as breakage and crack.

It is an object of the present invention to provide a film for semiconductor which can improve a pickup property and manufacture a semiconductor device having high reliability while preventing generation of defects in a semiconductor element, and a method for manufacturing a semiconductor device using such a film for semiconductor.

In order to achieve the object described above, the present invention is directed to a film for semiconductor comprising a bonding layer, at least one adhesive layer and a support film which are laminated together in this order, the film for semiconductor being adapted to be used for picking up chips obtained by laminating a semiconductor wafer onto a surface of the bonding layer opposite to the adhesive layer, and then dicing the semiconductor wafer together with the bonding layer in the laminated state into the chips,
wherein in the case where adhesive strength measured when an edge portion of the chip is peeled off from the adhesive layer is defined as "a (N/cm)" and adhesive strength measured when a portion of the chip other than the edge portion thereof is peeled off from the adhesive layer is defined as "b (N/cm)", a/b is in the range of 1 to 4.
According to such a present invention, it is possible to obtain a film for semiconductor which can suppress defects such as breakage and crack which would be generated in the chip (that is, a semiconductor element with a diced bonding layer) due to local impartation of a large load thereto when being picked up.

Further, in the film for semiconductor according to the present invention, it is preferred that the adhesive strength "b" is in the range of 0.05 to 0.3 (N/cm).

Further, in the film for semiconductor according to the present invention, it is preferred that a peripheral edge of the bonding layer is located inside a peripheral edge of the adhesive layer.

Further, in the film for semiconductor according to the present invention, it is preferred that a region of a surface of the adhesive layer facing the bonding layer, above which the semiconductor wafer is to be laminated, has been, in advance, irradiated with an ultraviolet ray before the semiconductor wafer is laminated onto the film for semiconductor.

Further, in the film for semiconductor according to the present invention, it is preferred that the at least one adhesive layer comprises a plurality of adhesive layers.

Further, in the film for semiconductor according to the present invention, it is preferred that the plurality of adhesive layers include a first adhesive layer positioned at a side of the semiconductor wafer, and a second adhesive layer provided between the first adhesive layer and the support film, the second adhesive layer having an adhesive property larger than that of the first adhesive layer.

Further, in the film for semiconductor according to the present invention, it is preferred that the peripheral edge of the bonding layer and a peripheral edge of the first adhesive layer are located inside a peripheral edge of the second adhesive layer, respectively.

Further, in the film for semiconductor according to the present invention, it is preferred that hardness of the second adhesive layer is smaller than that of the first adhesive layer.

Further, in the film for semiconductor according to the present invention, it is preferred that Shore D hardness of the first adhesive layer is in the range of 20 to 60.

In order to achieve the other object described above, the present invention is directed to a method for manufacturing a semiconductor device comprising:
a first step of laminating a semiconductor wafer onto the above film for semiconductor so that the semiconductor wafer makes contact with the bonding layer to obtain a laminated body;
a second step of dicing the semiconductor wafer into a plurality of semiconductor elements by forming cutting lines into the laminated body from a side of the semiconductor wafer; and
a third step of picking up the chips each comprising the semiconductor element with the diced bonding layer.
According to such a present invention, use of such a film for semiconductor makes it possible to improve a yield ratio of manufacturing semiconductor devices and to obtain semiconductor devices each having high reliability.

Further, in the method for manufacturing a semiconductor device according to the present invention, it is preferred that the cutting lines are formed so that deepest points thereof come down to the support film.

Further, in the method for manufacturing a semiconductor device according to the present invention, it is preferred that a cross sectional area of a distal end portion of each cutting line, which extends beyond an interface between the bonding layer and the adhesive layer, is in the range of 5 × 10⁻⁵ to 300 × 10⁻⁵ mm².

### BRIEF DESCRIPTION OF THE DRAWINGS

FIG. 1 is a view (sectional view) for explaining a first embodiment of the film for semiconductor of the present invention and the method for manufacturing a semiconductor device of the present invention.
FIG. 2 is a view (sectional view) for explaining a first embodiment of the film for semiconductor of the present invention and the method for manufacturing a semiconductor device of the present invention.
FIG. 3 is a view for explaining a method for producing the film for semiconductor of the present invention.
FIG. 4 is a view (sectional view) for explaining a method for measuring adhesive strength between a first adhesive layer and a bonding layer.
FIG. 5 is a view (sectional view) for explaining another embodiment of the method for manufacturing a semiconductor device of the present invention.
FIG. 6 is a view (sectional view) for explaining a second embodiment of the film for semiconductor of the present invention and the method for manufacturing a semiconductor device of the present invention.

### MODE FOR CARRYING OUT THE INVENTION

Hereinbelow, a film for semiconductor of the present invention and a method for manufacturing a semiconductor device of the present invention will be described in detail based on preferred embodiments shown in the accompanying drawings.

### <First Embodiment>

First, description will be made on a first embodiment of the film for semiconductor of the present invention and the method for manufacturing a semiconductor device of the present invention.

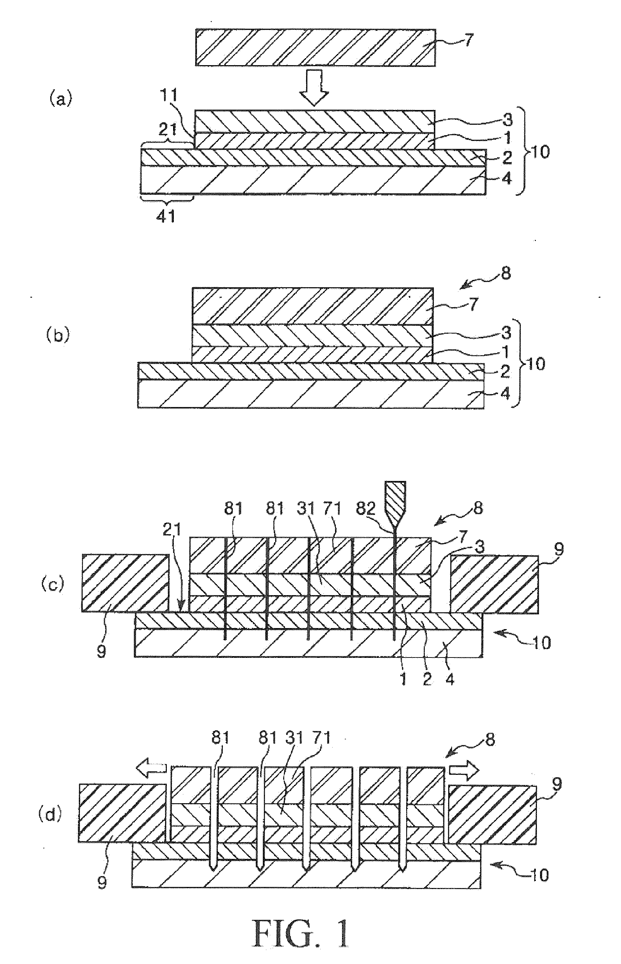

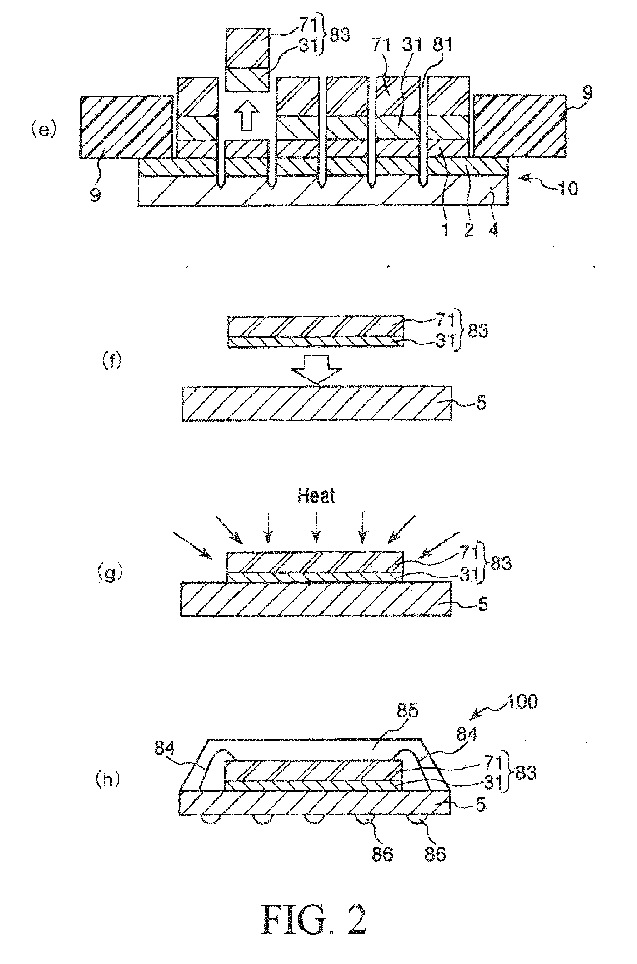

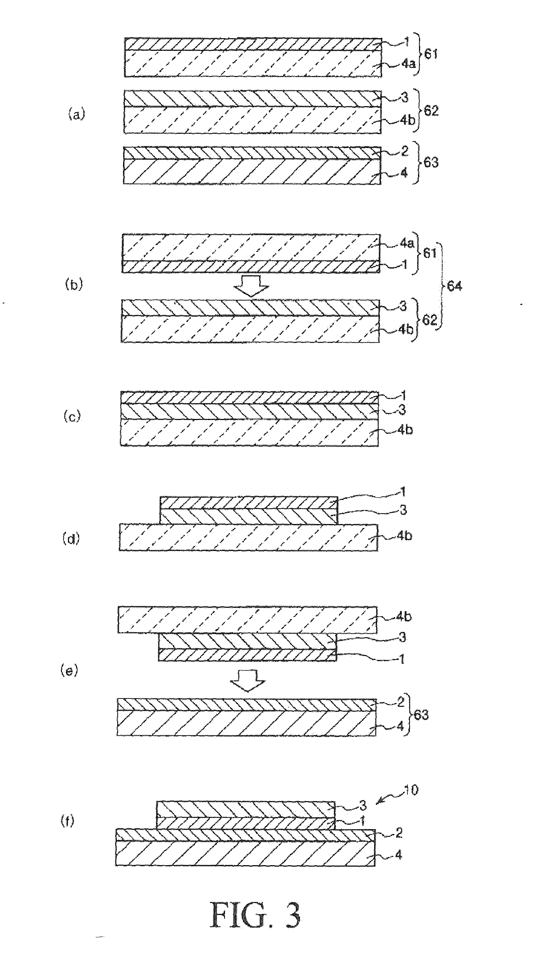

Each of FIGs. 1 and 2 is a view (sectional view) for explaining the first embodiment of the film for semiconductor of the present invention and the method for manufacturing a semiconductor device of the present invention, and FIG. 3 is a view for explaining a method for producing the film for semiconductor of the present invention. In this regard, in the following description, the upper side in each of FIGs. 1 to 3 will be referred to as "upper" and the lower side thereof will be referred to as "slower".

### [Film for Semiconductor]

A film for semiconductor 10 shown in FIG. 1 includes a support film 4, a first adhesive layer 1, a second adhesive layer 2 and a bonding layer 3. More specifically, in the film for semiconductor 10, the second layer 2, the first layer 1 and the bonding layer 3 are laminated together in this order on the support film 4.

Such a film for semiconductor 10 has a function of supporting a semiconductor wafer 7 laminated onto an upper surface of the bonding layer 3 when the semiconductor wafer 7 is separated into semiconductor elements 71 by being diced as shown in FIG. 1(a). Further, the film for semiconductor 10 also has a function of providing a diced bonding layer 31 for bonding the semiconductor element 71 onto an insulating substrate 5 by selectively peeling off the bonding layer 3 from the adhesive layer 1 when picking up the semiconductor element 71 (that is, the diced semiconductor wafer 7).

Further, a peripheral portion 41 of the support film 4 and a peripheral portion 21 of the second adhesive layer 2 exist beyond and outside a peripheral edge 11 of the first adhesive layer 1, respectively.

A wafer ring 9 is attached onto the peripheral portion 21 among them. This makes it possible for the semiconductor wafer 7 to be reliably supported by the film for semiconductor 10.

Meanwhile, when the semiconductor element 71 is picked up, it is required that the semiconductor element 71 is pulled up at a load (tensile load) more than adhesive strength between the first adhesive layer 1 and the bonding layer 3. However, in the conventional film for semiconductor, adhesive strength of an edge portion of the semiconductor element is different from that of a central portion of the semiconductor element. This causes lowering of a pickup property. As a result, there is a fear that defects such as breakage and crack of the semiconductor element are generated when being picked up.

In order to solve such a problem, the present inventors earnestly have examined conditions that can pick up the semiconductor element successfully while preventing the defects thereof from being generated. As a result, in order to achieve the above object, it is found that effective is a condition that when adhesive strength of the semiconductor element 71, which is obtained by laminating the semiconductor wafer 7 onto the film for semiconductor 10 and then dicing the semiconductor wafer 7, is measured, a ratio of "a (N/cm)" which is adhesive strength of an edge portion of the semiconductor element 71 to "b (N/cm)" which is adhesive strength of a central portion (other than the edge portion) of the semiconductor element 71 (that is, a/b) is in the range of 1 to 4.

According to such a film for semiconductor 10, variation of loads at every portions of the semiconductor element 71 is suppressed in a relatively narrow range. This makes it possible to reliably suppress generation of the defects such as the breakage and the crack in the semiconductor element 71. Use of the film for semiconductor 10 makes it possible to improve a yield ratio of manufacturing semiconductor devices 100 and to finally obtain semiconductor devices 100 each having high reliability. In this regard, it is to be noted that the above features will be described below in detail.

Hereinbelow, first, detail description will be made on a configuration of each part of the film for semiconductor 10 sequentially.

### (First Adhesive Layer)

The first adhesive layer 1 is formed from a general adhesive. Specifically, the first adhesive layer 1 is formed from a first resin composition containing an acryl-based adhesive, a rubber-based adhesive or the like.

Examples of the acryl-based adhesive include a resin constituted from (meth)acrylic acid and ester thereof, a copolymer obtained by polymerizing (meth)acrylic acid and ester thereof with a copolymerizable unsaturated monomer (e.g., vinyl acetate, styrene, acrylonitrile), and the like. Further, two or more kinds of these resins may be mixed with each other.

Among them, preferable is a copolymer obtained by polymerizing one or more selected from a group consisting of methyl (meth)acrylate, ethyl hexyl (meth)acrylate and butyl (meth)acrylate with one or more selected from a group consisting of hydroxyethyl (meth)acrylate and vinyl acetate. This makes it possible to easily control an adhesive property or tenacity of the first adhesive layer 1 to an opposing member (adherend) to which the first adhesive layer 1 is allowed to adhere.

Further, the first resin composition may contain urethane acrylate, acrylate monomer or a monomer or oligomer of an isocyanate compound such as a polyvalent isocyanate compound (e.g., 2,4-tolylene diisocyanate, 2,6-tolylene diisocyanate) or the like, in order to control the adhesive property (bonding property) thereof.

Furthermore, in the case where the first adhesive layer 1 is cured by an ultraviolet ray or the like, the first resin composition may contain: an acetophenone-type compound such as methoxy acetophenone, 2,2-dimethoxy-2-phenyl acetophenone, 2,2-diethoxy acetophenone, 2-methyl-1-[4-(methyl thio)-phenyl]-2-morpholino profane-1; a benzophenone-type compound; a benzoin-type compound; a benzoin isobutyl ether-type compound; a benzoin methyl benzoate-type compound; a benzoin benzoic acid-type compound; a benzoin methyl ether-type compound; a benzyl phenyl sulfide-type compound; a benzyl-type compound; a dibenzyl-type compound; a diacetyl-type compound or the like, as a photo polymerization initiator.

Moreover, in order to improve bonding strength and Share strength of the first adhesive layer 1, the first resin composition may contain a tackifier such as rosin resin, terpene resin, coumarone resin, phenol resin, styrene resin, aliphatic-type petroleum resin, aromatic-type petroleum resin, aliphatic aromatic-type petroleum resin, or the like.

An average thickness of such a first adhesive layer 1 is not limited to a specific value, but is preferably in the range of about 1 to 100 µm, and more preferably in the range of about 3 to 50 µm. If the thickness is less than the above lower limit value, there is a case that it is difficult to maintain the adhesive strength of the first adhesive layer 1 sufficiently. On the other hand, even if the thickness exceeds the above upper limit value, the properties of the first adhesive layer 1 are not substantially changed, and any advantages also cannot be obtained.

If the thickness falls within the above range, the first adhesive layer 1 cannot be peeled off from the bonding layer 3 when being diced and can be peeled off therefrom relatively easily according to a tensile load when being picked up, namely, the first adhesive layer 1 can exhibit a excellent dicing property and a superior pickup property.

### (Second Adhesive Layer)

The second adhesive layer 2 has an adhesive property higher than that of the first adhesive layer 1. Therefore, adhesion of the wafer ring 9 with respect to the second adhesive layer 2 becomes stronger than adhesion of the bonding layer 3 with respect to the first adhesive layer 1. This makes it possible to reliably fix the wafer ring 9 to the second adhesive layer 2 when dicing the semiconductor wafer 7 to separate into the semiconductor elements 71 during a second step. As a result, displacement of the semiconductor wafer 7 can be reliably prevented, to thereby suppress dimensional accuracy of the semiconductor elements 71 from being lowered.

As the second adhesive layer 2, one similar to the above first adhesive layer 1 can be used. Specifically, the second adhesive layer 2 is formed from a second resin composition containing an acryl-based adhesive, a rubber-based adhesive or the like.

Examples of the acryl-based adhesive include a resin constituted from (meth)acrylic acid and ester thereof, a copolymer obtained by polymerizing (meth)acrylic acid and ester thereof with a copolymerizable unsaturated monomer (e.g., vinyl acetate, styrene, acrylonitrile), and the like. Further, two or more kinds of these resins may be mixed with each other.

Among them, preferable is a copolymer obtained by polymerizing one or more selected from a group consisting of methyl (meth)acrylate, ethyl hexyl (meth)acrylate and butyl (meth)acrylate with one or more selected from a group consisting of hydroxyethyl (meth)acrylate and vinyl acetate. This makes it possible to easily control an adhesive property or tenacity of the second adhesive layer 2 to an opposing member (adhered) to which the second adhesive layer 2 is allowed to adhere.

Further, the second resin composition may contain urethane acrylate, acrylate monomer or a monomer or oligomer of an isocyanate compound such as a polyvalent isocyanate compound (e.g., 2,4-tolylene diisocyanate, 2,6-tolylene diisocyanate) or the like, in order to control the adhesive property (bonding property) thereof.

Furthermore, the second adhesive composition may contain the same photo polymerization initiator as described in the first adhesive composition.

Moreover, in order to improve a bonding strength and Share strength of the second adhesive layer 2, the second resin composition may contain a tackifier such as rosin resin, terpene resin, coumarone resin, phenol resin, styrene resin, aliphatic-type petroleum resin, aromatic-type petroleum resin, aliphatic aromatic-type petroleum-resin, or the like.

An average thickness of such a second adhesive layer 2 is not limited to a specific value, but is preferably in the range of about 1 to 100 µm, and more preferably in the range of about 3 to 20 µm. If the thickness is less than the above lower limit value, there is a case that it is difficult to maintain the adhesive strength of the second adhesive layer 2 sufficiently. On the other hand, even if the thickness exceeds the above upper limit value, the second adhesive layer 2 cannot exhibit especially excellent effects.

Further, the second adhesive layer 2 has plasticity higher than that of the first adhesive layer 1. Therefore, if the average thickness of the second adhesive layer 2 falls within the above range, a shape-following property of the second adhesive layer 2 can be maintained, to thereby further improve the adhesive property of the film for semiconductor 10 with respect to the semiconductor wafer 7.

### (Bonding Layer)

The bonding layer 3 is, for example, formed of a third resin composition containing a thermoplastic resin and a thermosetting resin. Such a resin composition has a good film-forming property, an excellent bonding property and superior heat resistance after being cured.

Examples of the thermoplastic resin include: a polyimide-based resin such as polyimide resin or polyetherimide resin; a polyamide-based resin such as polyamide resin or polyamideimide resin; an acryl-based resin; phenoxy resin; and the like. Among them, the acryl-based resin is preferable. Since the acryl-based resin has a low glass transition temperature, it is possible to further improve an initial adhesive property of the bonding layer 3.

In this regard, it is to be noted that the acryl-based resin means a polymer of acrylic acid and derivatives thereof. Specifically, examples of the acryl-based resin include a polymer of acrylic acid, methacrylic acid, an acrylate such as methyl acrylate or ethyl acrylate, a methacrylate such as methyl methacrylate or ethyl methacrylate, acrylonitrile, acryl amide, or the like, a copolymer obtained by polymerizing such a monomer with another monomer, and the like.

Further, among these acryl-based resins, preferable is an acryl-based resin (especially, an acrylate copolymer) containing a compound (copolymerizable monomer component) having a functional group such as an epoxy group, a hydroxyl group, a carboxyl group or a nitrile group. This makes it possible to further improve the adhesive property of the bonding layer 3 to the adherend such as the semiconductor element 71.

Specifically, examples of the compound having the functional group include glycidyl methacrylate having a glycidyl ether group, hydroxyl methacrylate having a hydroxyl group, carboxyl methacrylate having a carboxyl group, acrylonitrile having a nitrile group, and the like.

Furthermore, an amount of the compound having the functional group contained in the third resin composition is not limited to a specific value, but is preferably in the range of about 0.5 to 40 wt%, and more preferably in the range of about 5 to 30 wt% with respect to a total amount of the acryl-based resin. If the amount is less than the above lower limit value, there is a case that the effect of improving the adhesive property of the bonding layer 3 is lowered. On the other hand, if the amount exceeds the above upper limit value, there is a case that the adhesive strength of the bonding layer 3 becomes too large so that an effect of improving a working property is lowered.

Moreover, a glass transition temperature of the thermoplastic resin is not limited to a specific value, but is preferably in the range of -25 to 120°C, more preferably in the range of -20 to 60°C, and even more preferably in the range of -10 to 50°C. If the glass transition temperature is less than the above lower limit value, there is a case that the adhesive sterngth of the bonding layer 3 becomes too large so that an effect of improving a working property is lowered. On the other hand, if the glass transition temperature exceeds the above upper limit value, there is a case that the effect of improving an adhesive property of the bonding layer 3 at a low temperature is lowered.

In addition, a weight average molecular weight of the thermoplastic resin (especially, the acryl-based resin) is not limited to a specific value, but is preferably 100,000 or more, and more preferably in the range of 150,000 to 1,000,000. If the weight average molecular weight falls within the above range, it is possible to especially improve the film-forming property of the bonding layer 3.

On the other hand, examples of the thermosetting resin include: a novolac-type phenol resin such as phenol novolac resin, cresol novolac resin, bisphenol A novolac resin; a phenol resin such as resol phenol resin; an epoxy resin such as a bisphenol-type epoxy resin (e.g., bisphenol A epoxy resin, bisphenol F epoxy resin), a novolac-type epoxy resin (e.g., novolac epoxy resin, cresol novolac epoxy resin), a biphenyl-type epoxy resin, a stilbene-type epoxy resin, a triphenol methane-type epoxy resin, an alkyl-modified triphenol methane-type epoxy resin, a triazine chemical structure-containing epoxy resin or a dicyclopentadiene-modified phenol-type epoxy resin; a resin containing a triazine ring such as urea resin or a melamine resin; an unsaturated-polyester resin; a bismaleimide resin; a polyurethane resin; a diallyl phthalate resin; a silicone resin; a resin containing a benzoxazine chemical structure; a cyanate ester resin; and the like. A mixture containing one or more of them also may be used.

Further, among them, the epoxy resin or the phenol resin is preferable. By using these resins, it is possible to further improve the heat resistance and the adhesive property of the bonding layer 3.

Further, an amount of the thermosetting resin contained in the third resin composition is not limited to a specific value, but is preferably in the range of about 0.05 to 100 parts by weight, and more preferably in the range of about 0.1 to 50 parts by weight with respect to 100 parts by weight of the thermoplastic resin. If the amount exceeds the above upper limit value, there is a case that chipping and crack are generated in the bonding layer 3 or a case that the effect of improving the effect of improving the adhesive property of the bonding layer 3 is lowered. On the other hand, if the amount is less than the above lower limit value, there is a case that the adhesive strength of the bonding layer 3 becomes too large so that pickup defects occur or the effect of improving the working property is lowered.

Furthermore, it is preferred that the third resin composition further contains a curing agent (especially, a phenol-based curing agent in the case of the thermosetting resin being the epoxy resin).

Examples of the curing agent includes: an amine-type curing agent such as an aliphatic polyamine (e.g., diethylene triamine (DETA), triethylene tetramine (TETA), metaxylylene diamine (MXDA)), an aromatic polyamine (e.g., diamino diphenyl methane (DDM), m-phenylene diamine (MPDA), diamino diphenyl sulfone (DDS)), dicyandiamide (DICY) or a polyamine compound containing organic acid dihydrazide; an acid anhydride-type curing agent such as an aliphatic acid anhydride (liquid acid anhydride) (e.g., hexahydro phthalic anhydride (HHPA), methyl tetrahydro phthalic acid anhydride (MTHPA)) or an aromatic acid anhydride (e.g., trimellitic acid anhydride (TMA), pyromellitic acid dianhydride (PMDA), benzophenone tetracarboxylic acid dianhydride (BTDA)); or a phenol-type curing agent such as phenol resin.

Among them, the phenol-type curing agent is preferable. Specifically, examples of the phenol-type curing agent include: bisphenols such as bis (4-hydroxy-3,5-dimethyl phenyl) methane (common name: tetramethyl bisphenol F), 4,4'-sulfonyl diphenol, 4,4'-isopropylidene diphenol (common name: bisphenol A ), bis(4-hydroxyphenyl) methane, bis(2-hydroxyphenyl) methane, (2-hydroxyphenyl) (4-hydroxyphenyl) methane and a mixture of the bis(4-hydroxyphenyl) methane, the bis(2-hydroxyphenyl) methane and the (2-hydroxyphenyl) (4-hydroxyphenyl) methane (e.g., "bisphenol F-D" produced by Honshu Chemical Industry Co., Ltd.); dihydroxybenzenes such as 1,2-benzenediol, 1,3-benzenediol and 1,4-benzenediol; trihydroxybenzenes such as 1,2,4-benzenetriol; various isomers of dihydroxynaphthalenes such as 1,6-dihydroxynaphthalene; various isomers of biphenols such as 2,2'-biphenol and 4,4'-biphenol; and the like.

Further, an amount of the curing agent (especially, the phenol-based curing agent) contained in the third resin composition is not limited to a specific value, but is preferably in the range of 1 to 90 parts by weight, and more preferably in the range of about 3 to 60 parts by weight with respect to 100 parts by weight of the thermoplastic resin. If the amount is less than the above lower limit value, there is a case that the effect of improving the heat resistance of the bonding layer 3 is lowered. On the other hand, if the amount exceeds the above upper limit value, there is a case that storage stability of the bonding layer 3 is lowered.

Furthermore, in the case where the above mentioned thermosetting resin is the epoxy resin, a ratio between an epoxy equivalent and an equivalent of the curing agent can be determined by calculation. Specifically, a ratio of the epoxy equivalent of the epoxy resin to the equivalent of the functional group of the curing agent (e.g., a hydroxyl equivalent in the case of the phenol resin) is preferably in the range of 0.5 to 1.5, and more preferably in the range of 0.7 to 1.3. If the ratio is less than the above, lower limit value, there is a case that the storage stability of the bonding layer 3 is lowered. On the other hand, if the ratio exceeds the above upper limit value, there is a case that the effect of improving the heat resistance of the bonding layer 3 is lowered.

In addition, it is preferred that the third resin composition further contains a curing catalyst, if needed. This makes it possible to improve curability of the bonding layer 3.

Examples of the curing catalyst include an amine-type catalyst such as imidazoles, 1,8-diazabicyclo(5,4,0)undecene, a phosphorous-type catalyst such as triphenyl phosphine, and the like. Among them, the imidazoles are preferable. This makes it possible for the bonding layer 3 to especially combine fast curability and the storage stability.

Examples of the imidazoles include 1-benzyl-2-methyl imidazole, 1-benzyl-2-phenyl imidazole, 1-cyanoethyl-2-ethyl-4-methyl imidazole, 2-phenyl-4-methyl imidazole, 1-cyanoethyl-2-phenyl imidazolium trimellitate, 2,4-diamino-6-[2'-methyl imidazolyl-(1')]-ethyl-s-triazine, 2,4-diamino-6-[2'-undecyl imidazolyl-(1')]-ethyl-s-triazine, 2,4-diamino-6-[2'-ethyl-4'-methyl imidazolyl-(1')]-ethyls-triazine, 2,4-diamino-6-[2'-methyl imidazolyl-(1')]-ethyl-s-triazine isocyanurate adduct, 2-phenyl imidazole isocyanurate adduct, 2-phenyl-4,5-dihydroxymethyl imidazole, 2-phenyl-4-methyl-5-dihydroxymethyl imidazole, 2,4-diamino-6-vinyl-s-triazine, 2,4-diamino-6-vinyl-s-triazine isocyanurate adduct, 2,4-diamino-6-methacryloyloxyethyl-s-triazine, 2,4-diamino-6-methacryloyloxyethyl-s-triazine isocyanurate adduct, and the like.

Among them, the 2-phenyl-4,5-dihydroxymethyl imidazole or the 2-phenyl-4-methyl-5-dihydroxymethyl imidazole is preferable. This makes it possible to especially improve the storage stability of the bonding layer 3.

Further, an amount of the curing catalyst contained in the third resin composition is not limited to a specific value, but is preferably in the range of about 0.01 to 30 parts by weight, and more preferably in the range of about 0.5 to 10 parts by weight with respect to 100 parts by weight of the thermoplastic resin. If the amount is less than the above lower limit value, there is a case that the curability of the bonding layer 3 is insufficient. On the other hand, if the amount exceeds the above upper limit value, there is a case that the storage stability of the bonding layer 3 is lowered.

Furthermore, an average particle size of the curing catalyst is not limited to a specific value, but is preferably 10 µm or less, and more preferably in the range of 1 to 5 µm. If the average particle size falls within the above range, the curing catalyst can especially exhibit excellent reactivity.

Moreover, it is preferred that the third resin composition further contains a coupling agent, if needed. This makes it possible to further improve adhesive strength between a resin and an adherend and adhesive strength of a resin interface.

Examples of the coupling agent include a silane-type coupling agent, a titanium-type coupling agent, an aluminum-type coupling agent, and the like. Among them, the silane-type coupling agent is preferable. This makes it possible to further improve the heat resistance of the bonding layer 3.

Examples of the silane-type coupling agent include vinyl trichlorosilane, vinyl trimethoxysilane, vinyl triethoxysilane, β-(3,4-epoxycyclohexyl) ethyl trimethoxysilane, γ-giycidoxypropyl trithoxysilane, γ-glycidoxypropyl methyl diethoxysilane, γ-methacryloxypropyl trimethoxysilane, γ-methacryloxypropyl methyl diethoxysilane, γ-methacryloxypropyl triethoxysilane, N-β-(aminoethyl) γ-aminopropyl methyl dimethoxysilane, N-β-(aminoethyl) γ-aminopropyl trimethoxysilane, N-β-(aminoethyl) γ-aminopropyl triethoxysilane, γ-aminopropyl trimethoxysilane, γ-aminopropyl triethoxysilane, N-phenyl-γ-aminopropyl trimethoxysilane, γ-chlcropropyl trimethoxysilane, γ₋mercaptopropyl trimethoxysilane, 3-isocyanatepropyl triethoxysilane, 3-acryloxypropyl trimethoxysilane, bis(3-triethoxysilyl propyl) tetrasulfane, and the like.

An amount of the coupling agent contained in the third resin composition is not limited to a specific value, but is preferably in the range of about 0.01 to 10 parts by weight, and more preferably in the range of about 0.5 to 10 parts by weight with respect to 100 parts by weight of the thermoplastic resin. If the amount is less than the above lower limit value, there is a case that the adhesive effect of the bonding layer 3 is insufficient. On the other hand, the amount exceeding the above upper limit value causes generation of outgases or voids within the bonding layer 3.

When the bonding layer 3 is formed, the bonding layer 3 can be obtained by dissolving such a third resin composition into a solvent such as methyl ethyl ketone, acetone, toluene or dimethyl formamide to bring into a vanish state, applying the same onto a carrier film using a comma coater, a die coater, a gravure coater or the like, and then drying it.

An average thickness of the bonding layer 3 is not limited to a specific value, but is preferably in the range of about 3 to 100 µm, and more preferably in the range of about 5 to 70 µm. If the thickness falls within the above range, it is possible to control thickness accuracy of the bonding layer 3 in a very easy manner.

Further, the third resin composition may contain a filler, if needed. By containing the filler in the third resin composition, it is possible to improve a mechanical property and a bonding property of the bonding layer 3.

Examples of the filler include particles made of silver, titanium oxide, silica, mica or the like.

Further, an average particle size of the filler is preferably in the range of about 0.1 to 25 µm. If the average particle size is less than the above lower limit value, the effect of adding the filler to the third resin composition is lowered. On the other hand, if the average particle size exceeds the above upper limit value, there is a possibility that the bonding property of the bonding layer 3 required as the film is lowered.

An amount of the filler contained in the third resin composition is not limited to a specific value, but is preferably in the range of about 0.1 to 100 parts by weight, and more preferably in the range of about 5 to 90 parts by weight with respect to 100 parts by weight of the thermoplastic resin. This makes it possible to further improve the bonding property of the bonding layer 3 while enhancing the mechanical property thereof.

### (Support film)

The support film 4 is a base material for supporting the first adhesive layer 1, the second adhesive layer 2 and the bonding layer 3 as described above.

Examples of a constituent material of the support film 4 include polyethylene, polypropylene, polybutene, polybutadiene, polymethyl pentene, polyvinyl chloride, vinyl chloride copolymer, polyethylene terephthalate, polybutylene terephthalate, polyurethane, ethylene-vinyl acetate copolymer, ionomer, ethylene-(meth)acrlylic acid copolymer, ethylene-(meth)acrlylate copolymer, polystyrene, vinyl polyisoprene, polycarbonate and the like, and a mixture containing two or more of them and the like.

An average thickness of the support film 4 is not limited to a specific value, but is preferably in the range of about 5 to 200 µm, and more preferably in the range of about 30 to 150 µm. In this case, since the support film 4 has appropriate rigidity, it can reliably support the first adhesive layer 1, the second adhesive layer 2 and the bonding layer 3. This makes it possible to easily handle the film for semiconductor 10. Further, this also makes it possible for the film for semiconductor 10 to be bent appropriately, to thereby improve the adhesive property of the bonding layer 3 to the semiconductor wafer 7.

### (Properties of Film for Semiconductor)

Although the first adhesive layer 1, the second adhesive layer 2 and the bonding layer 3 have different adhesive strengths, respectively, they preferably have the following properties.

First, it is preferred that the adhesive strength of the first adhesive layer 1 with respect to the bonding layer 3 is smaller than the adhesive strength of the second adhesive layer 2 with respect to the support film 4. In this case, when a chip 83 is picked up during a third step described below, the second adhesive layer 2 is not peeled off from the support film 4, but the bonding layer 3 is selectively peeled off from the first adhesive layer 1. Further, the wafer ring 9 can reliably support (fix) a laminated body 8 when being diced.

Namely, since the two adhesive layers including the first adhesive layer 1 and the second adhesive layer 2 are used in this embodiment, by making the adhesive strengths thereof different from each other, it is possible to combine the reliable fixation of the laminated body 8 and the easy pickup of the chip 83. In other words, it is possible to balance between the dicing property and the pickup property of the film for semiconductor 10.

In this regard, it is to be noted that the adhesive strength of the first adhesive layer 1 with respect to the bonding layer 3 and the adhesive strength of the second adhesive layer 2 with respect to the wafer ring 9 can be adjusted by changing the kind (formulation) of the acryl-based resin, the kind of the monomer, the amounts thereof, hardness and the like.

Further, the adhesive strength of the first adhesive layer 1 with respect to the bonding layer 3 before being diced is not limited to a specific value, but is preferably in the range of about 10 to 80 cN/25mm (4 to 32 N/m), and more preferably in the range of about 30 to 60 cN/25mm (12 to 24 N/m) as an average value at an adhesive interface therebetween. If the adhesive strength falls within the above range, it is possible to prevent defects such as removal of the semiconductor element 71 from the first adhesive layer 1 when the laminated body 8 is extended (expanded) or diced as described below, and to maintain the excellent pickup property of the film for semiconductor 10.

In this regard, it is to be noted that the adhesive strength (cN/25mm) indicates a load (unit: cN) measured by forming a sample (laminated film) in which the bonding layer 3 has attached to a surface of the first adhesive layer 1 into a strip shape having a width of 25 mm, and then removing a portion corresponding to the bonding layer 3 from the sample at a peel off angle of 180° and a pull speed of 1,000 mm/min and at 23°C (room temperature). Namely, herein, the adhesive strength of the first adhesive layer 1 with respect to the bonding layer 3 is defined as "180° peel strength".

Examples of a formulation of the first adhesive layer 1 having the property described above include a mixture containing 1 to 50 parts by weight of the acrylate monomer and 0.1 to 10 parts by weight of the isocyanate compound with respect to 100 parts by weight of the acryl-based resin.

On the other hand, the adhesive strength of the second adhesive layer 2 with respect to the wafer ring 9 is not limited to a specific value, but is preferably in the range of about 100 to 2,000 cN/25mm (40 to 800 N/m), and more preferably in the range of about 400 to 1,200 cN/25mm (160 to 480 N/m) as an average value at an adhesive interface therebetween. If the adhesive strength falls within the above range, it is possible to prevent defects such as removal of the semiconductor element 71 from the first adhesive layer 1, which would be resulted from prevention of peel off of the first adhesive layer 1 from the second adhesive layer 2 at the interface therebetween, when the laminated body 8 is extended (expanded) or diced as described below, and to reliably support (fix) the laminated body 8 by the wafer ring 9.

In this regard, it is to be noted that the adhesive strength (cN/25mm) indicates a load (unit: cN) measured by attaching a strip adhesive tape having a width of 25 mm to an upper surface of the wafer ring 9 at 23°C (room temperature), and then peeling off the adhesive tape from the wafer ring 9 at a peel off angle of 180° and a pull speed of 1,000 mm/min and at 23°C (room temperature). Namely, herein, the adhesive strength of the second adhesive layer 2 with respect to the wafer ring 9 is defined as "180° peel strength".

Examples of a formulation of the second adhesive layer 2 having the property described above include a mixture containing 1 to 50 parts by weight of the urethane acrylate and 0.5 to 10 parts by weight of the isocyanate compound with respect to 100 parts by weight of the acryl-based resin.

In this regard, in the case where the adhesive strength of the first adhesive layer 1 with respect to the bonding layer 3 is defined as "A₁" and the adhesive strength of the second adhesive layer 2 with respect to the first adhesive layer 1 is defined as "A₂", A₂/A₁ is not limited to a specific value, but is preferably in the range of about 5 to 200, and more preferably in the range of about 10 to 50. This makes it possible for the first adhesive layer 1, the second adhesive layer 2 and the bonding layer 3 to especially exhibit the excellent dicing property and the superior pickup property.

Further, it is preferred that the adhesive strength of the first adhesive layer 1 with respect to the bonding layer 3 is smaller than the adhesive strength of the bonding layer 3 with respect to the semiconductor wafer 7. This makes it possible to prevent the semiconductor wafer 7 from being involuntarily peeled off from the bonding layer 3 at the interface therebetween when the chip 83 is picked up. Namely, this makes it possible to selectively peel off the bonding layer 3 from the first adhesive layer 1 at the interface therebetween.

In this regard, it is to be noted that the adhesive strength of the bonding layer 3 with respect to the semiconductor wafer 7 is not limited to a specific value, but is preferably in the range of about 50 to 500 cN/25mm (20 to 200 N/m), and more preferably in the range of about 80 to 250 cN/25mm (32 to 100 N/m). In the adhesive strength falls within the above range, it is possible to sufficiently prevent jump and removal of the semiconductor elements 71, so-called "chip jump", from occurring.

Further, it is preferred that the adhesive strength of the first adhesive layer 1 with respect to the bonding layer 3 is smaller than the adhesive strength of the first adhesive layer 1 with respect to the second adhesive layer 2. This makes it possible to prevent the first adhesive layer 1 from being involuntarily peeled off from the second adhesive layer 2 at the interface therebetween when the chip 83 is picked up. Namely, this makes it possible to selectively peel off the first adhesive layer 1 from the second adhesive layer 2 at the interface therebetween.

In this regard, it is to be noted that the adhesive strength of the first adhesive layer 1 with respect to the second adhesive layer 2 is not limited to a specific value, but is preferably in the range of about 100 to 1,000 cN/25mm (40 to 400 N/m), and more preferably in the range of about 300 to 600 cN/25mm (120 to 240 N/m). If the adhesive strength falls within the above range, it is possible to make the dicing property and the pickup property of the film for semiconductor 10 especially excellent.

### (Method for Producing Film for Semiconductor)

The film for semiconductor 10 as described above can be produced using, for example, the following method.

First, a base member 4a shown in FIG. 3 (a) is prepared, and then the first adhesive layer 1 is formed on one surface of the base member 4a. In this way, a laminated body 61 including the base member 4a and the first adhesive layer 1 is obtained. The formation of the first adhesive layer 1 can be carried out using a method in which a resin varnish containing the above mentioned first resin composition is applied onto the base member 4a by various kinds of application methods to obtain a coating film, and then the coating film is dried, a method in which a film formed of the first resin composition is laminated onto the base member 4a, or the like. Further, the coating film may be cured by being irradiated with a radial ray such as an ultraviolet ray.

Examples of the application methods include a knife coating method, a roll coating method, a spray coating method, a photogravure coating method, a bar coating method, a curtain coating method and the like.

Further, as shown in FIG. 3(a), the bonding layer 3 is formed on one surface of a prepared base member 4b in the same manner as the laminated body 61. In this way, a laminated body 62 including the base member 4b and the bonding layer 3 is obtained.

Furthermore, as shown in FIG. 3(a), the second adhesive layer 2 is formed on one surface of the prepared support film 4 in the same manner as each of the laminated body 61 and the laminated body 62. In this way, a laminated body 63 including the support film 4 and the second adhesive layer 2 is obtained.

Next, as shown in FIG. 3(b), the laminated body 61 is laminated onto the laminated body 62 so that the first adhesive layer 1 makes contact with the bonding layer 3, to thereby obtain a laminated body 64. This lamination can be carried out using, for example, a roll lamination method or the like.

Next, as shown in FIG. 3(c), the base member 4a is removed from the laminated body 64. Then, as shown in FIG. 3(d), a ring-shaped region outside an effective area of the bonding layer 3 and the first adhesive layer 1 is removed from the laminated body 64 without the base member 4a so as to leave the base member 4b. Here, the effective region is defined as a region having an outer diameter which is larger than an outer diameter of the semiconductor wafer 7 and is smaller than an inner diameter of the wafer ring 9.

Next, as shown in FIG. 3(e), the laminated body 64, from which the base member 4a and the ring-shaped region outside the effective area have been removed, is laminated onto the laminated body 63 so that an exposed surface of the first adhesive layer 1 makes contact with the second adhesive layer 2. Thereafter, by peeling off the base member 4b from the bonding layer 3, the film for semiconductor 10 shown in FIG. 3(f) can be obtained.

### [Method for Manufacturing Semiconductor Device]

Next, description will be made on a method for manufacturing a semiconductor device 100 using the film for semiconductor 10 described above (that is, a first embodiment of the semiconductor device manufacturing method according to the present invention).

A semiconductor device manufacturing method shown in FIGs. 1 and 2 includes: a first step of laminating the semiconductor wafer 7 onto the film for semiconductor 10 to obtain the laminated body 8; a second step of forming cutting lines 81 into the laminated body 8 (dicing the semiconductor wafer 7) from a side of the semiconductor wafer 7 in a state that the wafer ring 9 is attached to a peripheral portion 21 of the film for semiconductor 10 so that the semiconductor wafer 7 and the bonding layer 3 are separated into a plurality of chips 83 each including the semiconductor element 71 and the diced bonding layer 31; a third step of picking up at least one chip 83; and a fourth step of mounting the picked up chip 83 onto an insulating substrate 5, to thereby obtain a semiconductor device 100.
Hereinbelow, each of the above steps will be sequentially described in detail.

### [1]

[1-1] First, the semiconductor wafer 7 and the film for semiconductor 10 are prepared. The semiconductor wafer 7 has a plurality of circuits which have, in advance, formed on a surface thereof. Examples of such a semiconductor wafer 7 include a compound semiconductor wafer such as a gallium arsenide semiconductor wafer or a gallium nitride semiconductor wafer in addition to a silicon wafer.

An average thickness of such a semiconductor wafer 7 is not limited to a specific value, but is preferably in the range of about 0.01 to 1 mm, and more preferably in the range of about 0.03 to 0.5 mm. According to the semiconductor device manufacturing method of the present invention, it is possible to dice the semiconductor wafer 7 having such a thickness easily and reliably without generating the defects such as the breakage and the crack therein.

[1-2] Next, as shown in FIG. 1(a), the semiconductor wafer 7 is laminated onto the film for semiconductor 10 described above so that the semiconductor wafer 7 makes close contact with the bonding layer 3 of the film for semiconductor 10 (that is, this step is the first step).

In this regard, it is to be noted that in the film for semiconductor 10 shown in FIG. 1, the shape of the bonding layer 3 at a plane view thereof has been, in advance, set to a shape having a size (outer diameter) which is larger than an outer diameter of the semiconductor wafer 7 and is smaller than the inner diameter of the wafer ring 9. Therefore, the whole lower surface of the semiconductor wafer 7 makes close contact with the whole upper surface of the bonding layer 3. In this way, it becomes possible for the semiconductor wafer 7 to be supported by the film for semiconductor 10.

As a result of the above lamination, as shown in FIG. 1(b), it is possible to obtain a laminated body 8 in which the semiconductor wafer 7 and the film for semiconductor 10 are laminated together.

### [2]

[2-1] Next, the wafer ring 9 is prepared. Thereafter, the wafer ring 9 is laminated onto the laminated body 8 so that a lower surface of the wafer ring 9 makes close contact with an upper surface of the peripheral portion 21 of the second adhesive layer 2. In this way, a peripheral portion of the laminated body 8 is supported (secured) by the wafer ring 9.

The wafer ring 9 is generally formed of various kinds of metal materials such as stainless steel and aluminum. Therefore, since the wafer ring 9 has high rigidity, it is possible reliably to prevent deformation of the laminated body 8.

Since the film for semiconductor 10 includes the two adhesive layers (that is, the first adhesive layer 1 and the second adhesive layer 2) having the different adhesive strengths, it is possible for the film for semiconductor 10 to balance between the dicing property and the pickup property by utilizing the different adhesive strengths.

[2-2] Next, prepared is a dicer table not shown in the drawings. The laminated body 8 is placed onto the dicer table so that the support film 4 makes contact with the dicer table.

Thereafter, as shown in FIG. 1(c), the plurality of cutting lines 81 are formed into the laminated body 8 (diced) using a dicing blade 82. The dicing blade 82 is formed from a disciform diamond blade or the like. The cutting lines 81 are formed by pressing the dicing blade 82 against a surface of the laminated body 8 located at a side of the semiconductor wafer 7 while rotating it. By relatively moving the dicing blade 82 with respect to the laminated body 8 along each space between the circuits formed on the semiconductor wafer 7, the semiconductor wafer 7 is diced into the plurality of semiconductor elements 71 (that is, this step is the second step).

Further, the bonding layer 3 is also diced into the plurality of diced bonding layers 31. Although vibration and impact are imparted to the semiconductor wafer 7 when being diced, since the lower surface of the semiconductor wafer 7 is supported by the film for semiconductor 10, the above vibration and impact can be absorbed. As a result, it is possible to reliably prevent the occurrence of the defects such as the breakage and the crack in the semiconductor wafer 7.

A depth of each cutting line 81 is not limited to a specific value as long as it passes through the semiconductor wafer 7 and the bonding layer 3. Namely, a distal end of each cutting line 81 has only to come down to either the first adhesive layer 1, the second adhesive layer 2 or the support film 4. This makes it possible to reliably dice the semiconductor wafer 7 and the bonding layer 3, respectively, to thereby form the semiconductor elements 71 and the diced bonding layers 31.

In this regard, in this embodiment, as shown in FIG. 1(c) , description will be made on a case that the distal end of each cutting line 81 comes down up to the support film 4. Since the thickness of the support film 4 is sufficiently larger than that of each of the first adhesive layer 1 and the second adhesive layer 2, it is possible to form each cutting line 81 so that the distal end thereof comes down to the support film 4 without considering accuracy of the dicing blade 82 in an up-down position and variation of the depths of the cutting lines 81, thereby improving ease of manufacturing the semiconductor elements 71.
In other words, in the case where each cutting line 81 is formed so that the distal end thereof is positioned within the first adhesive layer 1 or the second adhesive layer 2, since the up-down position of the dicing blade 82 has to be strictly controlled, there is a fear that manufacture efficiency of the semiconductor elements 71 is lowered.

### [3]

[3-1] Next, the laminated body 8 into which the plurality of cutting lines 82 have been formed is extended (expanded) in a radial pattern using a expander not shown in the drawings. In this way, as shown in FIG. 1(d), a pitch between the semiconductor elements 71 obtained by the dicing is widened in association with enlargement of a width of each cutting line 82. As a result, it is possible to prevent a semiconductor element 71 from interfering in another semiconductor element 71. This makes it possible to easily pick up the individual semiconductor elements 71.

In this regard, it is to be noted that the expander is configured so that the expanded state of the laminated body 8 also can be kept during steps described below.

[3-2] Next, one of the semiconductor elements 71 obtained by the dicing is pulled up using a die bonder not shown in the drawings while being adsorbed by a collet (chip adsorption section) of the die blonder. As a result, as shown in FIG. 2(e), the diced bonding layer 31 is selectively peeled off from the first adhesive layer 1 at the interface therebetween so that the chip 83, in which the semiconductor element 71 and the diced bonding layer 31 are laminated together, is picked up (that is, this step is the third step).

In this regard, the reason why the diced bonding layer 31 is selectively peeled off from the first adhesive layer 1 at the interface therebetween is because the adhesive strength of the interface between the support film 4 and the second adhesive layer 2 and the adhesive strength of the interface between the second adhesive layer 2 and the first adhesive layer 1 are larger than the adhesive strength of the interface between the first adhesive layer 1 and the bonding layer 3 due to the adhesive property of the second adhesive layer 2 higher than the adhesive property of the first adhesive layer 1. Namely, in the case where the semiconductor element 71 is picked up upward, the bonding layer 3 is selectively peeled off from the first adhesive layer 1 at the interface therebetween having the smallest adhesive strength among these three interfaces.

Further, in the case where the chip 83 is picked up, the chip 83 to be picked up may be selectively pushed up from a lower side of the film for semiconductor 10. In this case, since the chip 83 is pushed up within the laminated body 8, it becomes possible to further easily perform the pickup of the chip 83. In this regard, in order to push up the chip 83, used is a needle for pushing up the film for semiconductor 10 from the lower side thereof or the like.

### [4]

[4-1] Next, the insulating substrate 5 for mounting the semiconductor element 71 (chip) thereonto is prepared.

Examples of the insulating substrate 5 include a substrate having an insulating property on which the semiconductor element 71 can be mounted and provided with wirings (circuits), terminals and the like for electrically connecting the semiconductor element 71 to external elements.

Concrete examples of the insulating substrate 5 include: a flexible substrate such as a polyester copper-clad film substrate, a polyimide copper-clad film substrate or an alamido copper-clad film substrate; a rigid substrate such as a glass base copper-clad laminated substrate (e.g., a glass fabric-epoxy copper-clad laminated substrate), a composite copper-clad laminated substrate (e.g., a glass nonwoven fabric-epoxy copper-clad laminated substrate) or a heat resistant-thermoplastic substrate (e.g., a polyetherimide resin substrate, a polyether ketone resin substrate, a polysulfone-based resin substrate); a ceramics substrate such as an alumina substrate, an aluminium nitride substrate or a silicon carbide substrate; and the like.

In this regard, it is to be noted that a lead frame or the like may be used instead of the insulating substrate 5.

Thereafter, as shown in FIG. 2(f), the picked up chip 83 is mounted onto the insulating substrate 5.

[4-2] Next, as shown in FIG. 2(g), the chip 83 mounted on the insulating substrate 5 is heated and pressed. In this way, the semiconductor element 71 and the insulating substrate 5 are bonded (die bonded) together through the diced bonding layer 31 (that is, this step is the fourth step).

As for conditions of the heat and press, for example, a heat temperature is preferably in the range of about 100 to 300 °C, and more preferably in the range of about 100 to 200°C. Further, a press time is preferably in the range of about 1 to 10 seconds, and more preferably in the range of about 1 to 5 seconds.

After being heated and pressed, a heat treatment may be carried out. In this case, heat conditions are set to a heat temperature of preferably about 100 to 300°C and more preferably about 150 to 250°C, and a heat time of preferably about 1 to 240 minutes and more preferably about 10 to 60 minutes.

Thereafter, terminals of the semiconductor element 71 (not shown in the drawings) and terminals of the insulating substrate 5 (not shown in the drawings) are electrically connected together through wires 84. In this regard, it is to be noted that this connection may be carried out using a conductive paste, a conductive film or the like instead of the wires 84.

Then, the chip 83 mounted on the insulating substrate 5 and the wires 84 are sealed by a resin material, to thereby form a mold layer 85. Examples of the resin material constituting the mold layer 85 include various kinds of mold resins such as an epoxy-based resin.

Further, ball-shaped electrodes are bonded to terminals provided on a lower surface of the insulating substrate 5 (not shown in the drawings). In this way, it is possible to obtain a semiconductor device 100 shown in FIG. 2(h) in which the semiconductor element 71 is placed in a package.

According to the above method, since the semiconductor element 71 is picked up in the state that the diced bonding layer 31 is attached thereto so as to form the chip 83 during the third step, the diced bonding layer 31 can be directly used for bonding the semiconductor element 71 to the insulating substrate 5 during the fourth step. Therefore, a bonding agent or the like does not need to be separately prepared, which makes it possible to further improve efficiency for manufacturing the semiconductor devices 100.

Meanwhile, the film for semiconductor 10 (that is, the film for semiconductor of the present invention) includes the first adhesive layer 1 and the second adhesive layer 2 each having the optimized adhesive strength, so that when the semiconductor wafer 7 is laminated thereon, the semiconductor wafer 7 and the bonding layer 3 are diced, and then the adhesive strength of the obtained chip 83 in which the semiconductor element 71 and the bonding layer 31 are laminated together is measured, the ratio of "a (N/cm)" which is the adhesive strength of the edge portion of the chip 83 to "b (N/cm) " which is the adhesive strength of the central portion (other than the edge portion) of the chip 83 (that is, a/b) becomes in the range of 1 to 4.

According to such a film for semiconductor 10, it is possible to reliably suppress generation of the defects such as the breakage and the crack in the semiconductor element 71 when being picked up.

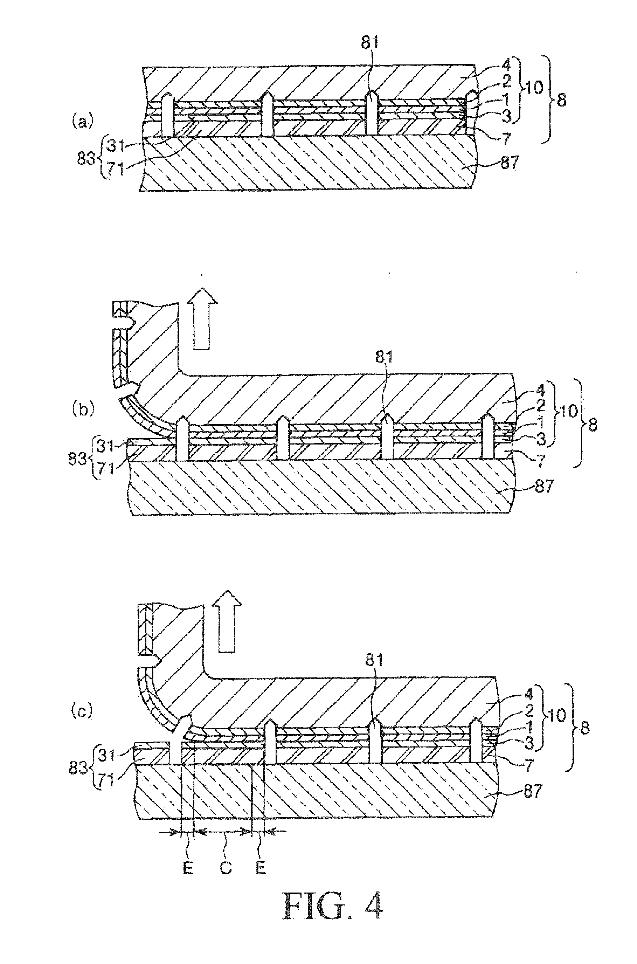

In this regard, it is to be noted that the adhesive strength "a" and the adhesive strength "b" are measured in detail as follows, respectively. FIG. 4 is the view (sectional view) for explaining the method for measuring adhesive strength between the first adhesive layer 1 and the bonding layer 3.

First, the semiconductor wafer 7 is laminated onto the film for semiconductor 10 to obtain the laminated body 8, and then the semiconductor wafer 7 is diced into 10 mm × 10 mm square. In this state, a strip adhesive film having a width of 1 cm adheres to an upper surface of the laminated body 8 which has not been applied to the third step yet at 23°C (room temperature) (see FIG. 4(a)).

Next, as shown in FIG. 4(b), the first adhesive layer 1, the second adhesive layer 2 and the support film 4 are peeled off (removed) from the laminated body 8 at a peel off angle of 90° and a pull speed of 50 mm/min, and at 23°C (room temperature). At this time, a magnitude of a tensile load (unit: N), to which each of the first adhesive layer 1, the second adhesive layer 2 and the support film 4 is imparted, is measured while peeling off the first adhesive layer 1, the second adhesive layer 2 and the support film 4.

An average value of the tensile loads, to which the first adhesive layer 1, the second adhesive layer 2 and the support film 4 are imparted (applied) when an edge portion "E" of the chip 83 is peeled off from the first adhesive layer 1, corresponds to the "adhesive strength "a"". On the other hand, as shown in FIG. 4(c), an average value of the tensile loads, to which the first adhesive layer 1, the second adhesive layer 2 and the support film 4 are imparted, when an central portion "C" (other than the edge portion) of the chip 83 is peeled off from the first adhesive layer 1 corresponds to the "adhesive strength "b"".

Namely, according to the film for semiconductor 10, even in the case of either the state shown in FIG. 4(b) (that is, the state that the edge portion "E" of the chip 83 is about to be separated from the first adhesive layer 1) or the state shown in FIG. 4(c) (that is, the state that the central portion "C" of the chip 83 is about to be separated from the first adhesive layer 1), it is possible to set a difference between the magnitudes of the tensile loads, to which the first adhesive layer 1, the second adhesive layer 2 and the support film 4 are imparted, within a relatively small range.

Therefore, even if warp of the semiconductor element 71 occurs, a degree of the warp is minimized as shown in FIG. 4(C). As a result, it is possible to minimize the defects such as the breakage and the crack in the semiconductor element 71.

In this regard, generally, in the case of peeling off a tabular chip such as the chip 83, adhesive strength of an edge portion thereof tends to be larger than adhesive strength of a central portion (other than the edge portion) thereof. It is conceived that this reason is mainly due to the following reasons.

At the edge portion "E" of the chip 83, ingredients contained in the first adhesive layer 1 and ingredients contained in the second adhesive layer 2, for example, creep up along an end surface of the chip 83 so that the end surface of the chip 83 contributes to make close contact with the first adhesive layer 1. Therefore, the adhesive strength of the edge portion "E" of the chip 83 tends to become larger than that of the central portion "C" thereof. This is one reason.

Further, in the case where the cutting lines 81 arrives at the base film 4, the base film 4 is shaved to produce shavings thereof. For example, the shavings stick to the end surface of the chip 83 when the chip 83 is peeled off so that the adhesive strength of the edge portion "E" locally increases. This is another reason.

On the other hand, according to the present invention, even if the above tendency exists, the difference between the adhesive strength of the central portion "C" and the adhesive strength of the edge portion "E" is optimized. This makes it possible to minimize the defects such as the breakage and the crack in the semiconductor element 71.

In this regard, the edge portion "E" of the chip 83 is defined as a portion extending up to 10% of a width of the semiconductor element 71 from an outer edge of the semiconductor element 71 (see FIG. 4). On the other hand, the central portion "C" of the chip 83 is defined as a portion other than the edge portion "E" (see FIG. 4). Namely, in the case where a shape of the semiconductor element 71 is a square having a size of 10 mm on a side at a plane view thereof, a portion having a width of 1 mm from an outer edge thereof is the edge portion "E" and a residual portion is the central portion "C".

Further, the a/b is in the range of 1 to 4, but is preferably in the range of about 1 to 3, and more preferably in the range of about 1 to 2. This makes it possible to further improve the pickup property of the chip 83.

Furthermore, it is preferred that the adhesive strength "b" of the central portion "C" (other than the edge portion "E") of the chip 83 falls within the range of the adhesive strength between the first adhesive layer 1 and the bonding layer 3. Then, the adhesive strength "b" is preferably in the range of about 0.05 to 0.3 N/cm (5 to 30 N/m), and more preferably in the range of abort 0.10 to 0.25 N/cm (10 to 25 N/m).

If the adhesive strength "b" falls within the above range, the pickup property of the chip 83 is especially improved. This makes it possible to prevent generation of the defects such as the breakage, the crack and burr in the semiconductor element 71. As a result, it is possible to finally manufacture semiconductor devices 100 each having a good reliability in a high yield ratio.

Especially, in the case of a semiconductor wafer 7 having a thin thickness (e.g., 200 µm or less), by setting the adhesive strength "b" to a value falling within the above range, the effect of preventing the above defects which would be generated in the semiconductor element 71 becomes remarkable.

Further, Shore D hardness of the first adhesive layer 1 is preferably in the range of about 20 to 60, and more preferably in the range of about 30 to 50. Since in such a first adhesive layer 1 having the above hardness, fluidity and flowability of ingredients contained therein can be relatively lowered while appropriately suppressing the adhesive property thereof, even in the case where the cutting lines 81 are formed into the first adhesive layer 1, the first adhesive layer 1 can exhibit both the effect of improving the pickup property and the effect of preventing the defects which would be generated due to exudation of the ingredients from the first adhesive layer 1.

Furthermore, Shore A hardness of the second adhesive layer 2 is preferably in the range of about 20 to 90, and more preferably in the range of about 30 to 80. Since in such a second adhesive layer 2 having the above hardness, fluidity and flowability of ingredients contained therein can be relatively lowered while having a sufficient adhesive property thereof, the second adhesive layer 2 can exhibit both the effect of improving the dicing property (e.g., stability between the laminated body 8 and the wafer ring 9 during the dicing step) and the effect of preventing the defects which would be generated due to exudation of the ingredients from the second adhesive layer 2.

Moreover, in order for the film for semiconductor 10 to exhibit the above properties, a cross sectional area of a distal end portion of one cutting line 81, which extends beyond the interface between the bonding layer 3 and the first adhesive layer 1, is preferably in the range of about 5×10⁻⁵ to 300×10⁻⁵ mm², and more preferably in the range of about 10×10⁻⁵ to 200×10⁻⁵ mm², but is varied depending on a thickness of the dicing blade 82 and/or the thickness of each of the first and second adhesive layers 1, 2.

By setting the cross sectional area of the portion of the cutting line 81 to a value falling within the above range, it is possible to suppress the exudation of the ingredients contained in the first adhesive layer 1 and/or the ingredients contained in the second adhesive layer 2 and the production of the shavings from the support film 4. As a result, it is possible to optimize the difference between the adhesive strengths of the edge portion of the semiconductor element 71 and the central portion thereof, to thereby further suppress the defects such as the breakage and the crack in the semiconductor element 71 from being generated.

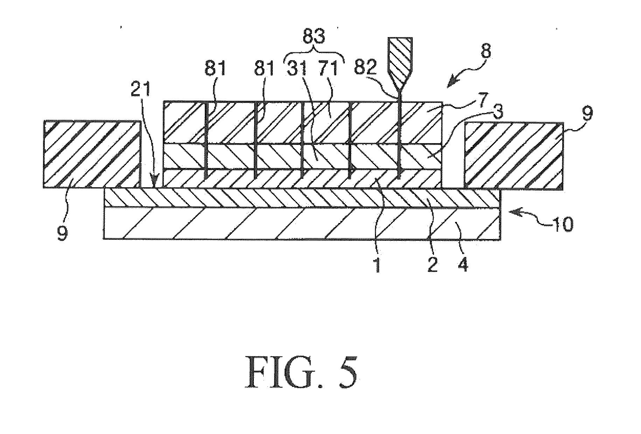

In this regard, FIG. 1 describes the case that the distal ends of the cutting lines 81 are formed so as to come down to the support film 4, but FIG. 5 describes a case that the distal ends of the cutting lines 81 are formed so as to be located within the first adhesive layer 1.

FIG. 5 is a view (sectional view) for explaining another embodiment of the method for manufacturing a semiconductor device of the present invention. In this regard, in the following description, the upper side in FIG. 5 will be referred to as "upper" and the lower side thereof will be referred to as "slower".

Hereinbelow, FIG. 5 will be described with emphasis placed on points differing from FIG. 1. No description will be made on the same points. In this regard, it is to be noted that the same reference numbers earlier described in FIG. 1 are applied to the same components shown in FIG. 5 as those of FIG. 1.

In FIG. 5, the cutting lines 81 are formed so that the distal ends thereof are located within the first adhesive layer 1. In the case where the cutting lines 81 are formed so that the distal ends thereof are located within the first adhesive layer 1 as described above, it is possible to prevent the ingredients contained in the second adhesive layer 2 from being exuded in the vicinity of the bonding layer 3 or in the vicinity of the semiconductor wafer 7.

As a result, it is possible to prevent defects such as disturbance of the pickup of the chip 83 which would occur due to involuntary enhancement of the adhesive strength between the bonding layer 3 and the first adhesive layer 1 (especially, the adhesive strength of the edge portion "E") by the exuded ingredients. Further, it is also possible to prevent alteration and deterioration of the semiconductor element 71 which would be caused by the exuded ingredients.

Since the adhesive property of the second adhesive layer 2 is higher than the adhesive property of the first adhesive layer 1 as described above, it is conceived that the second adhesive layer 2 necessarily has plasticity higher than that of the first adhesive layer 1. Therefore, fluidity and flowability of the ingredients contained in the second adhesive layer 2 are higher than those in the first adhesive layer 1, which is considered as a cause of the exudation of such ingredients.

Namely, in the case where a plurality of adhesive layers are provided like this embodiment and an adhesive property of an adhesive layer positioned at a side of the support film 4 (that is, the second adhesive layer 2 in FIG. 5) is higher than an adhesive property of an adhesive layer positioned at a side of the bonding layer 3 (that is, the first adhesive layer 1 in FIG. 5), it is especially effective that the distal ends of the cutting lines 81 are located within the first adhesive layer 1 as shown in FIG. 5 in order to prevent the above defects.

Further, in this embodiment, by locating the distal ends of the cutting lines 81 within the first adhesive layer 1, the semiconductor wafer 7 and the binding layer 3 are reliably diced, whereas the first adhesive layer 1 and the second adhesive layer 2 are not diced. This makes it possible to leave the first adhesive layer 1 and the second adhesive layer 2 intact on the support film 4 when the chip 83 is picked up during the third step so as to prevent the chip 83, to which the above adhesive layers adhere, from being involuntarily picked up.

This is because a successive state of each of the first adhesive layer 1 and the second adhesive layer 2 in a plane direction thereof is kept by not subjecting them to the dicing, which makes it possible to prevent the adhesive strength between the first adhesive layer 1 and the second adhesive layer 2 and the adhesive strength between the second adhesive layer 2 and the support film 4 from being reduced. Namely, this is because the adhesive strength between the first adhesive layer 1 and the second adhesive layer 2 and the adhesive strength between the second adhesive layer 2 and the support film 4 can sufficiently oppose to upward tensile strength to be generated when the chip 83 is picked up.

Furthermore, since the adhesive strength between the first adhesive layer 1 and the second adhesive layer 2 and the adhesive strength between the second adhesive layer 2 and the support film 4 are prevented from being reduced as described above, even in the case where the adhesive strength between the first adhesive layer 1 and the bonding layer 3 makes larger, it is possible to prevent the pickup property of the chip 83 from being lowered.

Namely, since an allowable margin of the adhesive strength between the first adhesive layer 1 and the bonding layer 3, which is able to appropriately pick up the chip 83, can be widened, there is also a merit in that ease for manufacturing the film for semiconductor 10 and the bonding property between the mounted semiconductor element 71 and the insulating substrate 5 are improved.

In this regard, it is to be noted that in the case of the method shown in FIG. 5, it is possible to obtain the same actions and effects as the method shown in FIG. 1.

### <Second Embodiment>

Next, description will be made on a second embodiment of the film for semiconductor of the present invention and the method for manufacturing a semiconductor device of the present invention.

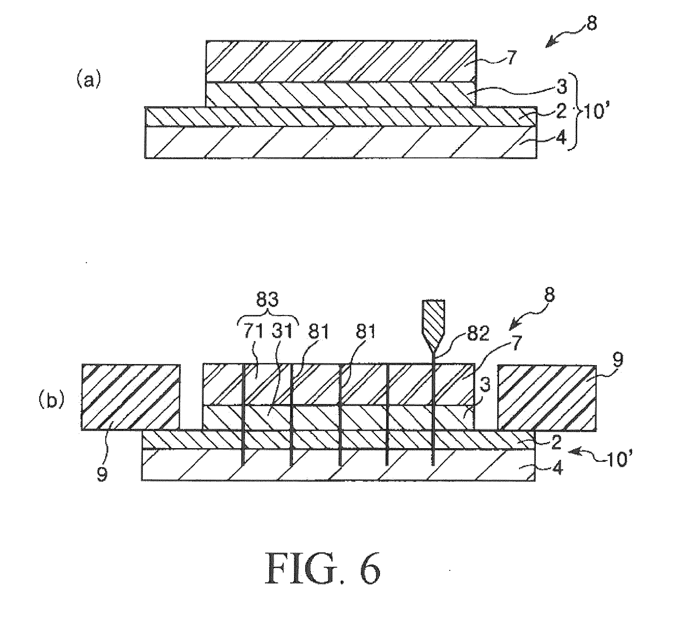

FIG. 6 is a view (sectional view) for explaining the second embodiment of the film for semiconductor of the present invention and the method for manufacturing a semiconductor device of the present invention. In this regard, in the following description, the upper side in FIG. 6 will be referred to as "upper" and the lower side thereof will be referred to as "lower".

Hereinbelow, the second embodiment will be described with emphasis placed on points differing from the first embodiment. No description will be made on the same points. In this regard, it is to be noted that the same reference numbers earlier described in FIG. 1 are applied to the same components shown in FIG. 6 as those of the first embodiment.

A film for semiconductor 10' shown in FIG. 6 is the same as the first embodiment except that the layer structure of the adhesive layer is different therefrom.

Namely, in the film for semiconductor 10' shown in FIG. 6, the first adhesive layer 1 is omitted, and only one layer formed from the second adhesive layer 2 is provided.

In the case where such a film for semiconductor 10' is produced, a region of an upper surface of the second adhesive layer 2 to be made contact with the bonding layer 3 (that is, a region above which the semiconductor wafer 7 is to be laminated) is, in advance, irradiated with an ultraviolet ray. In this way, an adhesive property of this region is deactivated, which makes it possible to reduce adhesive strength between the second adhesive layer 2 and the bonding layer 3. As a result, when the chip 83 is picked up during the third step, the chip 83 can be picked up without applying a large load thereto. In other words, it is possible to further improve the pickup property of the chip 83.

On the other hand, since a region of the upper surface of the second adhesive layer 2 to be not made contact with the bonding layer 3 is not irradiated with the ultraviolet ray, original adhesive strength of the second adhesive layer 2 is maintained in this region. Wherefore, the adhesive strength between the second adhesive layer 2 and the wafer ring 9 is also maintained, which prevents the dicing property of the film for semiconductor 10' from being lowered.

In other words, the first embodiment can combine the dicing property and the pickup property by utilizing the two adhesive layer having different adhesive properties. On the other hand, this embodiment can combine the dicing property and the pickup property in spite of the use of the single adhesive layer by lowering the adhesive property of only a part of the second adhesive layer 2.

Onto such a film for semiconductor 10', as shown in FIG. 6(a), a semiconductor wafer 7 is laminated, to thereby obtain a laminated body 8.

Next, as shown in FIG. 6(b), a plurality of cutting lines 81 are formed into the laminated body 8 using a dicing blade 82 (that is, dicing is carried out) . At this time, as shown in FIG. 6 (b), by carrying out the dicing so that the distal ends of the cutting lines 81 are located within the second adhesive layer 2, shavings of the support film 4 are impossible (hardly) to be produced. For this reason, it is possible to obtain the same actions and effects as the first embodiment.

Thereafter, the third step and the fourth step are carried out. In this way, it is possible to obtain a semiconductor device.

In this regard, a wavelength of the ultraviolet ray, with which the second adhesive layer 2 is irradiated, is preferably in the range of about 100 to 400 nm, and more preferably in the range of about 200 to 380 nm. Further, an irradiation time of the ultraviolet ray is preferably in the range of about 10 seconds to 1 hour, and more preferably in the range of about 30 seconds to 30 minutes depending on the wavelength or power thereof.

By using such an ultraviolet ray, it is possible to effectively deactivate the adhesive property of the second adhesive layer 2 and to prevent excessive lowering of the adhesive property thereof due to change of chemical structures in the second adhesive layer 2.

Further, the second adhesive layer 2 may be irradiated with various kinds of radioactive rays such as an electron ray and an X-ray instead of the ultraviolet ray.

In this regard, the region of the upper surface of the second adhesive layer 2 to be made contact with the bonding layer 3 may be not irradiated with the ultraviolet ray like this embodiment. For example, in the case where a constitute material of the second adhesive layer 2 is cured by being sensitized with the ultraviolet ray, the second adhesive layer 2 may be irradiated with the ultraviolet ray either after the bonding layer 3 is laminated thereon, after the bonding layer 3 and the semiconductor wafer 7 are laminated thereon or after the bonding layer 3 and the semiconductor wafer 7 are laminated thereon and then the semiconductor wafer 7 is diced.

In such cases, since the second adhesive layer 2 is cured due to the irradiation of the ultraviolet ray, an adhesive property of a region of the second adhesive layer 2 where is irradiated with the ultraviolet ray is lowered. As a result, even in these cases, it is possible to improve the pickup property of the chip 83.

While the descriptions are made on the film for semiconductor and the method for manufacturing a semiconductor device according to the present invention based on the embodiments shown in the drawings, the present invention is not limited thereto.

Examples of a type of the package include, but are not limited to, a surface mount-type package such as CSP (Chip Size Package) (e.g., BGA (Ball Grid Array), LGA (Land Grid Array)) or TCP (Tape Carrier Package), an insertion-type package such as DIP (Dual Inline Package) or PGA (Pin Grid Array), and the like.

Further, in the description of each embodiment, the chip 83 is mounted on the insulating substrate 5, but may be mounted on another chip. Tamely, the method for manufacturing a semiconductor device according to the present invention is used for manufacturing a chip stack-type semiconductor device in which a plurality of semiconductor elements are laminated together. This makes it possible to omit a fear that shavings or the like penetrate into a space between the semiconductor elements, to thereby manufacture a chip stack-type semiconductor device having high reliability in a high yield ratio.

In this regard, when the film for semiconductor of the present invention is subjected to the dicing, the cutting lines 81 have only to be formed so as to dice the semiconductor wafer 7 and the bonding layer 3. Therefore, a depth of each cutting line 81 is not limited to a specific value.

Further, arbitrary steps also may be added to the method for manufacturing a semiconductor device according to the present invention, if needed.

### Examples

Hereinbelow, concrete examples of the present invention will be described.

### 1. Manufacture of Semiconductor Device

### (Example 1)

### <1> Formation of First Adhesive Layer

100 parts by weight of a copolymer having a weight average molecular weight of 300,000 which was obtained by polymerizing 30 wt% of 2-ethyl hexyl acrylate with 70 wt% of vinyl acetate, 45 parts by weight of a penta-functional acrylate monomer having a molecular weight of 700, 5 parts by weight of 2,2-dimethoxy-2-phenyl acetophenone and 3 parts by weight of tolylene diisocyanate ("CORONATE T-100" produced by NIPPON POLYURETHANE INDUSTRY CORPORATION) were applied onto a polyester film having a thickness of 38 µm and subjected to a releasing treatment so that a thickness thereof after being dried would become 10 µm, and then dried at 80°C for 5 minutes to obtain an application film. Thereafter, the obtained application film was irradiated with an ultraviolet ray having 500 mJ/cm² to thereby form a first adhesive layer on the polyester film.

In this regard, it is to be noted that Shore D hardness of the obtained first adhesive layer was 40.

### <2> Formation of Second Adhesive Layer

100 parts by weight of a copolymer having a weight average molecular weight of 500,000 which was obtained by polymerizing 70 wt% of butyl acrylate with 30 wt% of 2-ethyl hexyl acrylate, 3 parts by weight of tolylene diisocyanate ("CORONATE T-100" produced by NIPPON POLYURETHANE INDUSTRY CORPORATION) were applied onto a polyester film having a thickness of 38 µm and subjected to a releasing treatment so that a thickness thereof after being dried would become 10 µm, and then dried at 80°C for 5 minutes. In this way, a second adhesive layer was formed on the polyester film. Whereafter, a polyethylene sheet having a thickness of 100 µm was laminated onto the second adhesive layer as a support film.

In this regard, it is to be noted that Shore A hardness of the obtained second adhesive layer was 80.

### <3> Formation of Bonding Layer

100 parts by weight of an acrylate copolymer having a weight average molecular weight of 500,000 and Tg of 6°C (a solid content contained in methyl ethyl ketone (MEK) dissolving an ethyl acrylate-butyl acrylate-acrylonitrile-acrylic acid-hydroxyethyl methacrylate copolymer "SG-708-6" produced by Nagase ChemteX Corporation), 9.8 parts by weight of phenoxy resin having a weight average molecular weight of 50,000 ("JER1256" produced by Japan Epoxy Resin Corporation), 90.8 parts by weight of spherical silica having an average particle size of 0.3 µm ("sic1050" produced by Admatechs) as a filler, 1.1 parts by weight of y-glycidoxypropyl trimethoxysilane ("KBM403E" produced by Shin-Etsu Chemical Corporation) as a coupling agent and 0.1 parts by weight of phenol resin having a hydroxyl equivalent of 104 g/OH group ("PR-53647" produced by Sumitomo Bakelite Co. Ltd.) were dissolved into methyl ethyl ketone, to thereby obtain a resin varnish having a resin solid content of 20 wt%.

Next, the obtained resin varnish was applied onto a polyethylene terephthalate film having a thickness of 38 µm (Product Number "prex A43" produced by Teijin DuPont Films Japan Limited) using a comma coater, and then dried at 150°C for 3 minutes, to thereby obtain a bonding layer having a thickness of 25 µm on the polyethylene terephthalate film.

### <4> Production of Film for Semiconductor

The film on which the first adhesive layer was formed was laminated onto the film on which the bonding layer was formed so that the first adhesive layer made contact with the bonding layer, and then the polyester film attaching to the first adhesive layer was peeled off therefrom, to thereby obtain a laminated body.

Next, the first adhesive layer and the bonding layer were punched out so as to have sizes larger than an outer diameter of a semiconductor wafer and smaller than an inner diameter of a wafer ring, and then an unnecessary portion was removed, to thereby obtain a second laminated body.

Further, the polyester film attaching to one surface of the second adhesive layer was peeled off therefrom. Thereafter, the second laminated body was laminated thereonto so that the first adhesive layer made contact with the second adhesive layer. In this way, obtained was a film for semiconductor in which the polyethylene sheet (support film), the second adhesive layer, the first adhesive layer, the bonding layer and the polyester film were laminated together in this order.

### <5> Manufacture of Semiconductor Device

Next, prepared was a silicon wafer having a thickness of 100 µm and a size of 8 inches.

Next, the polyester film was removed from the film for semiconductor, and then a silicon wafer) was laminated onto an exposed surface thereof at 60°C. In this way, obtained was a laminated body in which the polyethylene sheet (support film), the second adhesive layer, the first adhesive layer, the bonding layer and the silicon wafer were laminated together in this order.

Next, this laminated boy was diced (segmented) from a side of the silicon wafer using a dicing saw ("DFD6360" produced by DISCO Corporation) under the following conditions. In this way, the silicon wafer was diced, to thereby obtain semiconductor elements each having the following dicing size.

### <Dicing Conditions>

• Dicing Size: 10 mm × 10 mm square
• Dicing Speed: 50 mm/sec
• Speed of Rotation of Spindle: 40,000 rpm
• Dicing Maximum Depth: 0.130 mm (cutting amount from surface of silicon wafer)
• Thickness of Dicing Blade: 15 µm
• Cross Sectional Area of Cutting Line: 7.5×10⁻⁵ mm² (Cross Sectional Area of Distal End Portion Extending beyond Interface between Bonding Layer and First Adhesive Layer)

In this regard, it is to be noted that distal ends of cutting lines formed by being diced were located within the first adhesive layer.

Meanwhile, in order to estimate the pickup property of the semiconductor element on the laminated body into which the cutting lines were formed, measured was 90° peel strength (adhesive strength) of the semiconductor element (chip). This peel strength was defined as a load which was measured when a strip adhesive film having a width of 1 cm was attached to upper surfaces of the semiconductor elements at 23°C (room temperature), and then peeled off from the laminated body at a peel off angle off 90° and a pull speed off 50 mm/min and at 23°C (room temperature).

As a result off this measurement, in this Example, the peel strength was fitted into a narrow range of 0.1 to 0.3 N/cm.

Further, an average value of the peel strengths of the central portions of the chips was 0.15 N/cm, whereas an average value of the peel strengths of the edge portions of the chips was 0.25 N/cm. Namely, in the case where the peel strength of the former was defined as "b" and the peel strength of the latter was defined as "a", a/b was 1.67.

Whereafter, one of the semiconductor elements was pushed up from a rear surface of the film for semiconductor using a needle, and then pulled up using a die bonder while a surface of the semiconductor element was adsorbed by a collet of the die bonder. In this way, a chip including the semiconductor element and the diced bonding layer was picked up.

Next, the picked up chip was die bonded onto a bismaleimide triazine resin substrate coated with a solder resist (product name: "AUS308" produced by Taiyo Ink Mfg. Co., Ltd.) and having a circuit step of 5 to 10 µm by being pressed at a temperature of 130°C and at a load of 5 N for 10 seconds.

Whereafter, the semiconductor element and the resin substrate were electrically connected together by wire bonding.

Then, the semiconductor element on the resin substrate and the bonding wires were sealed by a mold resin (EME-G760), and then subjected to a heat treatment at a temperature of 175°C for 2 hours. In this way, the mold resin was cured, to thereby obtain a semiconductor device. In this regard, it is to be noted that 10 semiconductor devices were manufactured in this Example.

### (Example 2)

Semiconductor devices were manufactured in the same manner as Example 1, except that a part of the dicing conditions was changed as follows.

### <Dicing Conditions>

• Dicing Maximum Depth: 0.134 mm (cutting amount from surface of silicon wafer)
• Cross Sectional Area off Cutting Line: 13.5×10⁻⁵ mm² (Cross Sectional Area of Distal End Portion Extending beyond Interface between Bonding Layer and First Adhesive Layer)

In this regard, it is to be noted that distal ends of cutting lines formed by being diced were located within the first adhesive layer.

Further, in this Example, 180° peel strength was measured on the laminated body into which the cutting lines were formed like Example 1. As a result of this measurement, in this Example, the peel strength was also fitted into a narrow range of 0.1 to 0.3 N/cm.

Furthermore, an average value of the peel strengths of the central portions of the chips was 0.15 N/cm, whereas an average value of the peel strengths of the edge portions of the chips was 0.27 N/cm. Namely, in the case where the peel strength of the former was defined as "b" and the peel strength of the latter was defined as "a", a/b was 1.8.

### (Example 3)

Semiconductor devices were manufactured in the same manner as Example 1, except that a part of the dicing conditions was changed as follows.

### <Dicing Conditions>

-dicing Maximum Depth: 0.140 mm (cutting amount from surface of silicon wafer)
-Cross Sectional Area of Cutting Line: 22.5×10⁻⁵ mm² (Cross Sectional Area of Distal End Portion Extending beyond Interface between Bonding Layer and First Adhesive Layer)

In this regard, it is to be noted that distal ends of cutting lines formed by being diced were located within the second adhesive layer.

Further, in this Example, 180° peel strength was also measured on the laminated body into which the cutting lines were formed like Example 1. As a result of this measurement, in this Example, the peel strength was also fitted into a narrow range of 0.1 to 0.3 N/cm.

Furthermore, an average value of the peel strengths of the central portions of the chips was 0.15 N/cm, whereas an average value of the peel strengths of the edge portions of the chips was 0.28 N/cm. Namely, in the case where the peel strength of the former was defined as "b" and the peel strength of the latter was defined as "a"`, a/b was 1.87.

### (Example 4)

Semiconductor devices were manufactured in the same manner as Example 1, except that a part of the dicing conditions was changed as follows.

### <Dicing Conditions>

• Dicing Maximum Depth: 0.150 mm (cutting amount from surface of silicon wafer)
• Cross Sectional Area of Cutting Line: 37.5×10⁻⁵ mm² (Cross Sectional Area of Distal End Portion Extending beyond Interface between Bonding Layer and First Adhesive Layer)

In this regard, it is to be noted that distal ends of cutting lines formed by being diced arrived within the support film.

Further, in this Example, 180° peel strength was also measured on the laminated body into which the cutting lines were formed like Example 1. As a result of this measurement, in this Example, the peel strength was also fitted into a range of 0.1 to 0.4 N/cm, although it was slightly worse than those of Examples 1 to 3.

Furthermore, an average value of the peel strengths of the central portions of the chips was 0.15 N/cm, whereas an average value of the peel strengths of the edge portions of the chips was 0.35 N/cm. Namely, in the case where the peel strength of the former was defined as "b" and the peel strength of the latter was defined as "a", a/b was 2.33.

### (Example 5)

Semiconductor devices were manufactured in the same manner as Example 1, except that the first adhesive layer was omitted and a part of the steps was changed as follows.

### <1> Formation of Second Adhesive Layer

The second adhesive layer was formed in the same manner as Example 1, and then a region of a surface of the second adhesive layer corresponding to a shape and a size of a silicon wafer was irradiated with an ultraviolet ray. In this way, an adhesive property of the ultraviolet ray irradiated region was lowered.

### <2> Production of Film for Semiconductor

The film on which the bonding layer was formed was laminated onto the film on which the second adhesive layer was formed so that the bonding layer made contact with the ultraviolet ray irradiated region. In this way, obtained was a laminated body in which the polyethylene sheet (support film), the second adhesive layer, the bonding layer and the polyester were laminated together in this order. Thereafter, an unnecessary portion thereof was removed, to thereby obtain a film for semiconductor.

### <3> Manufacture of Semiconductor Device

The polyester film was removed from the film for semiconductor, and then a silicon wafer was laminated onto an exposed surface thereof. In this wary, obtained was a laminated body in which the polyethylene sheet (support film), the second adhesive layer, the bonding layer and the silicon wafer were laminated together in this order.

Next, this laminated boy was diced from a side of the silicon wafer. In this way, the silicon wafer was diced. In this regard, it is to be noted that distal ends of cutting lines formed by being diced were located within the second adhesive layer.

Hereinbelow, the semiconductor devices were manufactured in the same manner as Example 1.

Further, in this Example, 180° peel strength was also measured on the laminated body into which the cutting lines were formed like Example 1. As a result of this measurement, in this Example, the peel strength was also fitted into a narrow range of 0.1 to 0.4 N/cm, although it was slightly worse than those of Examples 1 and 2.

Furthermore, an average value of the peel strengths of the central portions of the chips was 0.12 N/cm, whereas an average value of the peel strengths of the edge portions of the chips was 0.37 N/cm. Namely, in the case where the peel strength of the former was defined as "b" and the peel strength of the latter was defined as "a", a/b was 3.08.

### (Comparative Example)

Semiconductor devices were manufactured in the same manner as Example 1, except that a part of the dicing conditions was changed as follows.

### <Dicing Conditions>

• Dicing Maximum Depth: 0.170 mm (cutting amount from surface of silicon wafer)
• Cross Sectional Area of Cutting Line: 67.5×10⁻⁵ mm² (Cross Sectional Area of Distal End Portion Extending beyond Interface between Bonding Layer and First Adhesive Layer)

In this regard, it is to be noted that distal ends of cutting lines formed by being diced were located within the polyethylene sheet (support film).

Further, in this Comparative Example, 180° peel strength was also measured on the laminated body into which the cutting lines were formed like Example 1. As a result of this measurement, in this Comparative Example, the peel strengths varied within a wide range of 0.1 to 1.0 N/cm.

Furthermore, an average value of the peel strengths of the central portions of the chips was 0.15 N/cm, whereas an average value of the peel strengths of the edge portions of the chips was 0.70 N/cm. Namely, in the case where the peel strength of the former was defined as "b" and the peel strength of the latter was defined as "a", a/b was 4.67.

### 2. Evaluation of Dicing Property and Pickup property

A dicing property of the film for semiconductor obtained in each of Examples and Comparative Example was good. Namely, in each of the semiconductor elements, breakage, crack or the like was not generated when being diced.

Further, it was confirmed that in each of Examples, the pickup of the semiconductor elements could be stably carried out. Therefore, in each of Examples, it becomes apparent that defects such as breakage and crack in each of the semiconductor elements, which would be generated due to local importation of a large load thereto, could be suppressed. Further, as a result of observation of the edge portions of the semiconductor elements after being picked up in each of Examples, it was confirmed that burrs or foreign materials such as shavings did not adhere thereto.

On the other hand, in Comparative Example, defects such as breakage and crack were generated in each of the semiconductor elements after being peeled off. Further, as a result of observation of the edge portions of the semiconductor elements after being picked up in Comparative Example, it was confirmed that burrs or foreign materials such as shavings adhered thereto.

### INDUSTRIAL APPLICABILITY

A film for semiconductor of the present invention comprises a bonding layer, at least one adhesive layer and a support film which are laminated together in this order. The film for semiconductor is adapted to be used for picking up chips obtained by laminating a semiconductor wafer onto an opposite surface of the bonding layer to the adhesive layer, and then dicing the semiconductor wafer together with the bonding layer in the laminated state into the chips. In the case where adhesive strength measured when an edge portion of the chip is peeled off from the adhesive layer is defined as "a (N/cm)" and adhesive strength measured when a portion of the chip other than the edge portion is peeled off from the adhesive layer is defined as "b (N/cm) ", a/b is in the range of 1 to 4.

This makes it possible to obtain a film for semiconductor that can reliably suppress defects such as breakage and crack which would be generated in the semiconductor element due to local importation of a large load thereto when being picked up. Further, use of such a film for semiconductor makes it possible to improve a yield ratio of manufacturing semiconductor devices and to obtain semiconductor devices each having high reliability. Therefore, the film for semiconductor of the present invention provides industrial applicability.

## Claims

1. A film for semiconductor comprising a bonding layer, at least one adhesive layer and a support film which are laminated together in this order, the film for semiconductor being adapted to be used for picking up chips obtained by laminating a semiconductor wafer onto a surface of the bonding layer opposite to the adhesive layer, and then dicing the semiconductor wafer together with the bonding layer in the laminated state into the chips,
wherein in the case where adhesive strength measured when an edge portion of the chip is peeled off from the adhesive layer is defined as "a (N/cm)" and adhesive strength measured when a portion of the chip other than the edge portion thereof is peeled off from the adhesive layer is defined as "b (N/cm)", a/b is in the range of 1 to 4.

2. The film for semiconductor as claimed in claim 1, wherein the adhesive strength "b" is in the range of 0.05 to 0.3 (N/cm).

3. The film for semiconductor as claimed in claim 1, wherein a peripheral edge of the bonding layer is located inside a peripheral edge of the adhesive layer.

4. The film for semiconductor as claimed in claim 1, wherein a region of a surface of the adhesive layer facing the bonding layer, above which the semiconductor wafer is to be laminated, has been, in advance, irradiated with an ultraviolet ray before the semiconductor wafer is laminated onto the film for semiconductor.

5. The film for semiconductor as claimed in claim 1, wherein the at least one adhesive layer comprises a plurality of adhesive layers.

6. The film for semiconductor as claimed in claim 5, wherein the plurality of adhesive layers include a first adhesive layer positioned at a side of the semiconductor wafer, and a second adhesive layer provided between the first adhesive layer and the support film, the second adhesive layer having an adhesive property larger than that of the first adhesive layer.

7. The film for semiconductor as claimed in claim 6, wherein the peripheral edge of the bonding layer and a peripheral edge of the first adhesive layer are located inside a peripheral edge of the second adhesive layer, respectively.

8. The film for semiconductor as claimed in claim 6, wherein hardness of the second adhesive layer is smaller than that of the first adhesive layer.

9. The film for semiconductor as claimed in claim 6, wherein Shore D hardness of the first adhesive layer is in the range of 20 to 60.

10. A method for manufacturing a semiconductor device comprising:
a first step of laminating a semiconductor wafer onto the film for semiconductor defined by claim 1 so that the semiconductor wafer makes contact with the bonding layer to obtain a laminated body;
a second step of dicing the semiconductor wafer into a plurality of semiconductor elements by forming cutting lines into the laminated body from a side of the semiconductor wafer; and
a third step of picking up the chips each comprising the semiconductor element with the diced bonding layer.

11. The method for manufacturing a semiconductor device as claimed in claim 10, wherein the cutting lines are formed so that deepest points thereof come down to the support film.

12. The method for manufacturing a semiconductor device as claimed in claim 10, wherein a cross sectional area of a distal end portion of each cutting line, which extends beyond an interface between the bonding layer and the adhesive layer, is in the range of 5 × 10⁻⁵ to 300 × 10⁻⁵ mm².
